# FASCICULE DE BREVET EUROPEEN

(11) **EP 2 550 572 B1**
(45) Date de publication et mention de la délivrance du brevet: **11.09.2019**
(21) Numéro de dépôt: 11715950.9
(22) Date de dépôt: 21.03.2011
(51) Int. Cl.: G06F 1/18, G11B 33/12, H05K 7/14

(54) **LAME A HAUTE DENSITE AVEC EXTRACTION A CHAUD DE COMPOSANTS POUR SYSTEME INFORMATIQUE**
HOCHDICHTER BLADESERVER MIT HOT-SWAPPING VON KOMPONENTEN FÜR EIN COMPUTERSYSTEM
HIGH-DENSITY BLADE WITH HOT-SWAPPING OF COMPONENTS FOR A COMPUTER SYSTEM

(30) Priorité: 23.03.2010 FR 1052099
(43) Date de publication de la demande: 30.01.2013
(73) Titulaire: Bull SAS, 78340 Les Clayes-sous-Bois (FR)
(72) Inventeur: CRISAN, Cornel, F-38700 La Tronche (FR); TEMPORELLI, Frédéric, F-38130 Echirolles (FR)
(74) Mandataire: Santarelli
(86) Numéro de dépôt international: PCT/FR2011/050566
(87) Numéro de publication internationale: WO 2011/117517

(56) Documents cités:
- WO-A1-2009/108205
- JP-A- 2003 036 669
- US-A1- 2007 230 110
- US-A1- 2008 307 141

## Description

La présente invention concerne d'une manière générale un système informatique avec une structure à lames disposées dans des boîtiers.

Plus particulièrement, la présente invention concerne des lames de composants informatiques, tels que des disques durs.

Dans le domaine des systèmes informatiques en général, on connaît des systèmes ayant une architecture à base de lames insérées dans des boîtiers, aussi appelés « racks ». Chacune des lames porte un certain nombre de composants informatiques tels que des disques durs ou des cartes électroniques. Les lames sont insérées dans les racks qui présentent des moyens de guidage pour insérer les lames et des connecteurs disposés parallèlement sur une face arrière du rack pour raccorder électriquement chacune des lames. Les lames présentent sur une tranche arrière des zones de connexion destinées à coopérer avec les connecteurs des racks.

Lorsqu'un composant informatique de l'une des lames nécessite d'être changé, il faut extraire la lame complète, privant ainsi le système informatique des autres composants de la lame en question pendant le temps de l'intervention.

Pour pallier à cela, il a été proposé de disposer les composants informatiques dans des compartiments débouchant sur la tranche avant de la lame. Cette solution permet d'interchanger "à chaud" les composants informatiques disposés dans les compartiments, c'est-à-dire sans avoir à mettre hors service l'ensemble des composants de la lame. Cependant, le nombre de composants qu'il est possible de disposer ainsi dans les compartiments frontaux est limité par la surface des tranches avant des lames, dictée par la taille des racks dont la taille est elle-même standardisée. De plus, avec cette solution, une partie des composants de la lame situés derrière les compartiments reste inaccessible sans démonter la lame.

La demande internationale WO 2009/108205 et la demande de brevet américain US 2008/307141 divulguent des lames de composants pour système informatique, pourvues des caractéristiques mentionnées dans le préambule de la revendication 1.

La présente invention vise à pallier ces inconvénients. Elle propose à cet effet un système informatique selon la revendication 1.

Ainsi, avantageusement, le système selon l'invention permet de maximiser le nombre de composants interchangeables au sein d'une même lame sans avoir à extraire celle-ci du boîtier. Il en résulte d'une part un gain de productivité dans la mesure où le temps d'intervention sur le système est limité et que les autres composants de la lame continuent à fonctionner pendant l'opération avec un impact minimal sur les performances du système informatique, et d'autre part un accroissement de la densité des composants, le volume utile de la lame étant plus important. On parle de lame à "haute densité" en composants avec extraction "à chaud" desdits composants.

Selon des caractéristiques avantageuses de l'invention, éventuellement combinées :
- les directions longitudinales des emplacements sont sensiblement parallèles entre elles, et le support présente au moins une carte électronique sensiblement perpendiculaire à l'ensemble des dites directions, ladite carte portant au moins une partie desdits connecteurs.
- des moyens formant butées sont prévus sur les dispositifs formant glissière pour limiter le débattement du support par rapport au châssis à la course comprise entre ladite première et ladite seconde position.
- au moins l'un des emplacements est adapté à recevoir un disque dur.

L'invention sera mieux comprise à la lecture de la description d'un exemple de réalisation de l'invention qui suit, donné à titre purement illustratif et non limitatif, en référence aux dessins annexés. Sur ceux-ci :
- la figure 1 est une vue latérale d'une lame selon l'invention ;
- la figure 2 est une vue de dessus de la même lame ;

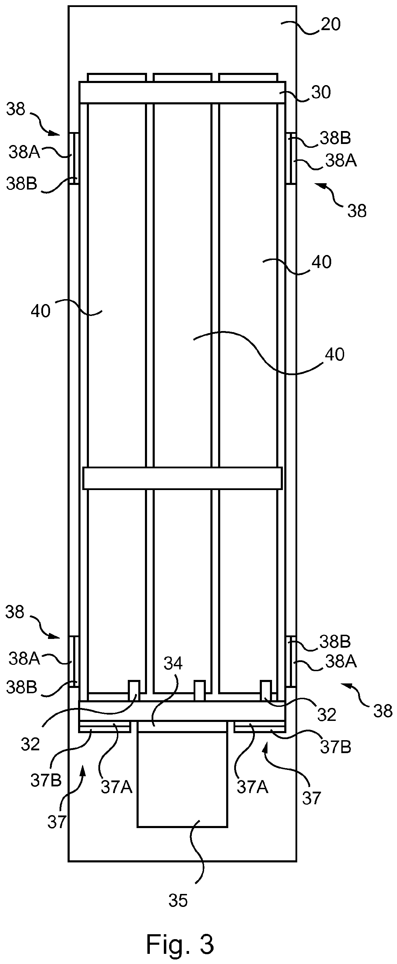

- la figure 3 est une vue arrière de la même lame ;
- la figure 4 est une vue latérale de la même lame en position d'extraction des composants.

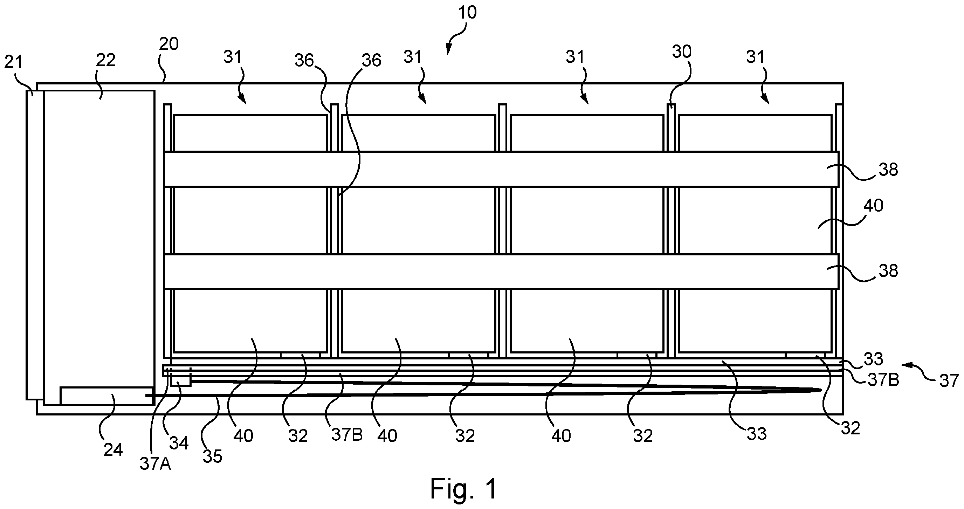

Comme visible plus particulièrement en figure 1, une lame 10 de composants 40 pour système informatique selon l'invention est dimensionnée pour être insérée dans un boîtier de système informatique (non représenté).

La lame comporte un châssis 20 présentant des moyens de raccordement électrique au boîtier informatique. En pratique, il s'agit d'un connecteur 21 mâle destiné à coopérer avec un connecteur femelle disposé dans le boîtier de système informatique (non représenté).

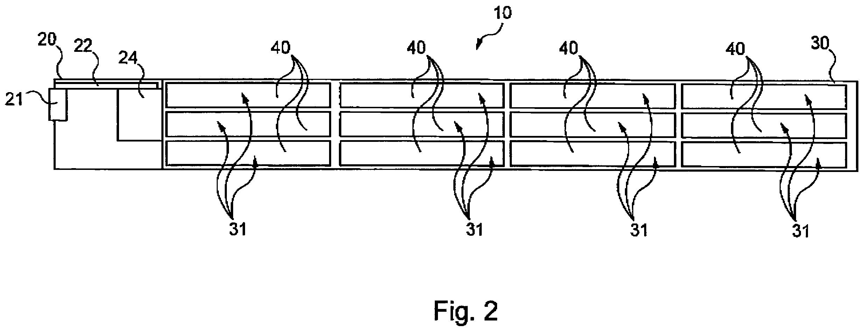

La lame comporte en outre un support 30 de composants informatiques présentant une architecture en paniers formant douze emplacements 31 pour des composants informatiques 40 comme visible plus particulièrement en figure 2.

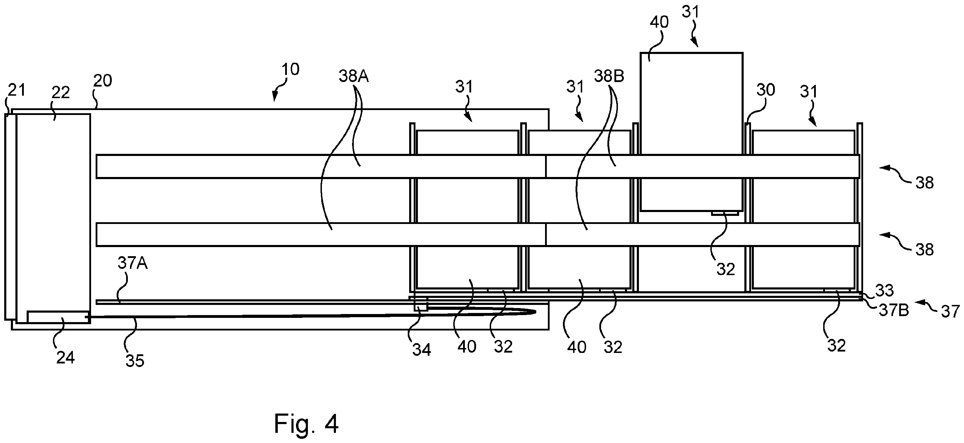

Comme visible en figures 1 et 4, le support 30 est monté mobile selon une liaison glissière par rapport au châssis 20.

Chacun des emplacements 31 présente sur son fond un connecteur 32 porté par une carte électronique 33 disposée au fond du support de composants de manière sensiblement perpendiculaire à la direction longitudinale de chacun des emplacements 31. La carte électronique 33 présente à un connecteur 34 rassemblant les connexions de tous les connecteurs pour équipement électronique 32. Le connecteur 34 est ensuite relié à l'aide d'une nappe 35 composée d'une pluralité de fils électriques à un connecteur 24 disposé sur une carte électronique 22 du châssis. La carte électronique 22 du châssis constitue un dispositif de commande pour les différents composants électroniques qui y sont reliés via la nappe 35. La carte électronique 22 porte en outre le connecteur 21 destiné à raccorder la lame au boîtier informatique. Ceci est plus particulièrement visible sur les figures 1 et 2.

La liaison glissière entre le châssis 20 et le support 30 est assurée par six dispositifs formant glissières disposés entre le châssis et le support. Il s'agit de deux glissières inférieures 37 conçues pour supporter le poids du support 30 en translation et de quatre glissières 38 conçues pour guider latéralement le support 30 dans le châssis 20.

Les glissières 38 sont, chacune, composées d'un rail 38A fixé par rapport au châssis 20 et d'un rail 38B, solidaire du support 30 et monté en liaison glissière avec le rail 38A.

Avantageusement, les glissières 38 présentent des moyens formant butées (non représentées) pour limiter la translation du support 30 par rapport au châssis 20.

De manière analogue, les glissières 37 présentent elles aussi composées, chacune, d'un rail 37A fixé par rapport au châssis 20 et d'un rail 37B, solidaire du support 30 et monté en liaison, glissière avec le rail 37A.

D'une manière connue en soi pour l'homme du métier, les rails 37A, 37B, 38A, 38B peuvent comporter des éléments réduisant le frottement entre les rails tels que des billes ou des patins réalisés en un matériau ayant un coefficient de frottement particulièrement adapté tel que par exemple le teflon®. Chacun des emplacements 31 comporte sur ses parois latérales des moyens de guidage destinés dans le présent exemple à accueillir des disques durs 40 en translation de manière à s'assurer que ceux-ci vont venir se raccorder électriquement au connecteur 32 lors de leur insertion dans chacun des emplacements 31. Dans le présent exemple il s'agit de rails 36 dimensionnés pour guider des disques durs de 2,5' du commerce.

Ainsi, comme visible plus particulièrement sur la figure 2, la lame 10 selon l'invention permet d'augmenter considérablement la quantité de composants 40 interchangeables sans avoir à déconnecter la lame du boîtier du système informatique. Pour une lame présentant les mêmes dimensions extérieures, la présente invention permet de disposer de douze emplacements 31 accessibles depuis l'extérieur sans démonter la lame, alors que dans la solution connue présentant des compartiments frontaux, le nombre de compartiments équivalents était limité à six. Ainsi, la densité des composants informatiques interchangeables à chaud, ici des disques durs de 2,5' du marché, est doublée avec la lame selon l'invention. La densité de composants dans une même lame s'en trouve sensiblement augmentée.

Comme visible plus particulièrement en figure 4, lorsque l'on souhaite extraire un composant 40 du support 30, il suffit de faire translater celui-ci par rapport au châssis 20 à la manière d'un tiroir, à l'aide de glissières 37 et 38. La nappe 35 va suivre ce moment. Le composant 40 choisi peut alors aisément être extrait par le haut comme visible en figure 4.

Le connecteur 34 est ici positionné à l'extrémité la plus proche du connecteur 24 de la carte 33.

Avantageusement, dans un mode de réalisation non représenté, le connecteur 34 est placé sensiblement au centre de la carte 33 ce qui réduit la longueur de la nappe 35 nécessaire ce qui améliore la qualité des signaux électriques et réduit le coût de production.

Bien entendu, de nombreuses modifications peuvent être apportées à l'exemple de réalisation décrit précédemment sans sortir du cadre de l'invention tel que défini par les revendications.

## Revendications

1. Système informatique comportant un boîtier de système informatique pourvu d'un connecteur, au moins une lame (10) de composants (40) pour système informatique destinée à être insérée dans ledit boîtier de système informatique et connectée audit connecteur dudit boîtier, des composants informatiques (40) reçus dans la dite lame, ladite lame comportant :
- un châssis (20) distinct dudit boîtier et comportant un connecteur mâle (21) de raccordement électrique de ladite lame connecté au connecteur dudit boîtier informatique ;
- un support (30) de composants informatiques distinct dudit châssis et distinct dudit boîtier et présentant une pluralité d'emplacements (31) débouchants adaptés à recevoir lesdits composants informatiques (40) à translation selon une direction longitudinale de l'emplacement ;
le support (30) de composants étant monté mobile selon une liaison glissière par rapport au châssis (20), entre une première position dans laquelle le support est sensiblement inséré dans le châssis et une seconde position dans laquelle le support est au moins partiellement extrait du châssis, de manière à laisser libre l'aplomb de l'ensemble des emplacements (31) selon la direction longitudinale de chacun d'entre eux pour permettre l'insertion et l'extraction des composants informatiques (40) par translation selon ladite direction longitudinale de chacun des emplacements ;
lesdits emplacements (31) présentant des moyens de guidage (36) en translation pour les composants informatiques, chacun des emplacements (31) présentant sur son fond un connecteur (32) raccordé au connecteur mâle (21) du châssis, le connecteur (32) étant adapté à raccorder électriquement le composant informatique lors de son insertion dans l'emplacement ;
- une nappe (35) de fils électriques connectant les connecteurs (32) desdits emplacements (31) à un connecteur intermédiaire (34) ;
**caractérisé en ce que** ladite lame comporte en outre:
- un dispositif de commande (22) monté sur le châssis et portant à la fois le connecteur intermédiaire (34) et le connecteur mâle (21), pour connecter les composants informatiques (40) au châssis via la nappe (35) et le connecteur intermédiaire (34) et pour commander ces composants informatiques (40) ;
- une carte électronique (33) portant les connecteurs (32) desdits emplacements (31) et étant disposée au fond et sur une face interne du support, entre les composants informatiques (40) et cette face interne ;
et **en ce que** la liaison glissière entre le châssis et le support est assurée par des glissières inférieures (37) et des glissières latérales (38) distinctes des glissières inférieures, toutes disposées entre le châssis et le support, les glissières inférieures ayant un rail (37A) fixé par rapport au châssis et un autre rail (37B) solidaire du support et supportant le poids du support en translation, et les glissières latérales ayant un rail (38A) fixé par rapport au châssis et un autre rail (38B) solidaire du support et guidant latéralement le support dans le châssis.

2. Système selon la revendication 1, **caractérisée en ce que** l'ensemble des directions longitudinales des emplacements (31) sont sensiblement parallèles entre elles, et la carte électronique (33) est sensiblement perpendiculaire à l'ensemble des dites directions.

3. Système selon la revendication précédente, **caractérisée en ce que** des moyens formant butées sont prévus sur les glissière inférieures et latérales (37,38) pour limiter le débattement du support par rapport au châssis à la course comprise entre ladite première et ladite seconde position.

4. Système selon l'une quelconque des revendications précédentes, **caractérisée en ce que** au moins l'un des emplacements est adapté à recevoir un disque dur (40).

## Patentansprüche

1. Computersystem, umfassend ein mit einem Verbinder versehenes Computersystemgehäuse, wenigstens ein Blade (10) mit Komponenten (40) für das Computersystem, das dazu bestimmt ist, in das Computersystemgehäuse eingefügt zu werden und mit dem Verbinder des Gehäuses verbunden zu werden, Computerkomponenten (40), die in dem Blade aufgenommen sind, wobei das Blade Folgendes umfasst:
- einen Rahmen (20), der sich von dem Gehäuse unterscheidet und einen männlichen Verbinder (21) zum elektrischen Anschluss des Blades umfasst, der mit dem Verbinder des Computergehäuses verbunden ist;
- eine Halterung (30) für Computerkomponenten, die sich von dem Rahmen unterscheidet und sich von dem Gehäuse unterscheidet und eine Vielzahl von mündenden Einbaustellen (31) aufweist, die dafür eingerichtet sind, die Computerkomponenten (40) durch eine Translationsbewegung entlang einer Längsrichtung der Einbaustelle aufzunehmen;
wobei die Komponentenhalterung (30) über eine Gleitverbindung in Bezug auf den Rahmen (20) beweglich montiert ist, und zwar zwischen einer ersten Position, in der die Halterung im Wesentlichen in den Rahmen eingefügt ist, und einer zweiten Position, in der die Halterung wenigstens teilweise aus dem Rahmen herausgezogen ist, um am Ort der gesamten Einbaustellen (31) in Längsrichtung von jeder von ihnen einen Freiraum zu lassen, um das Einfügen und Herausnehmen von Computerkomponenten (40) durch eine Translationsbewegung in der Längsrichtung von jeder der Einbaustellen zu ermöglichen; wobei die Einbaustellen (31) Mittel zur Führung (36) der Translationsbewegung für die Computerkomponenten aufweisen, wobei jede der Einbaustellen (31) an ihrem Boden einen Verbinder (32) aufweist, der an den männlichen Verbinder (21) des Rahmens angeschlossen ist, wobei der Verbinder (32) dafür eingerichtet ist, die Computerkomponente bei ihrem Einfügen in die Einbaustelle elektrisch anzuschließen;
- eine Schicht (35) aus elektrischen Drähten, welche die Verbinder (32) der Einbaustellen (31) mit einem Zwischenverbinder (34) verbindet;
**dadurch gekennzeichnet, dass** das Blade ferner Folgendes umfasst:
- eine Steuerungsvorrichtung (22), die an dem Rahmen montiert ist und gleichzeitig den Zwischenverbinder (34) und den männlichen Verbinder (21) trägt, um die Computerkomponenten (40) über die Schicht (35) und den Zwischenverbinder (34) mit dem Rahmen zu verbinden und um diese Computerkomponenten (40) zu steuern;
- eine elektronische Karte (33), welche die Verbinder (32) der Einbaustellen (31) trägt und am Boden und an einer Innenfläche der Halterung zwischen den Computerkomponenten (40) und dieser Innenfläche angeordnet ist;
und dass die Gleitverbindung zwischen dem Rahmen und der Halterung durch untere Gleitführungen (37) und sich von den unteren Gleitführungen unterscheidende seitliche Gleitführungen (38), die alle zwischen dem Rahmen und der Halterung angeordnet sind, sichergestellt wird, wobei die unteren Gleitführungen Folgendes aufweisen: eine Schiene (37A), die in Bezug auf den Rahmen feststehend ist und eine andere Schiene (37B), die mit der Halterung fest verbunden ist und das Gewicht der Halterung bei der Translationsbewegung trägt, und wobei die seitlichen Gleitführungen Folgendes aufweisen: eine Schiene (38A), die in Bezug auf den Rahmen feststehend ist und eine andere Schiene (38B), die mit der Halterung fest verbunden ist und die Halterung seitlich im Rahmen führt.

2. System nach Anspruch 1, **dadurch gekennzeichnet, dass** alle Längsrichtungen der Einbaustellen (31) im Wesentlichen parallel zueinander sind und die Elektronikkarte (33) im Wesentlichen senkrecht zu allen der genannten Richtungen ist.

3. System nach dem vorhergehenden Anspruch, **dadurch gekennzeichnet, dass** Anschläge bildende Mittel an den unteren Gleitführungen und seitlichen Gleitführungen (37, 38) vorgesehen sind, um die Verschiebung der Halterung in Bezug auf den Rahmen auf dem Weg zwischen der ersten und der zweiten Position zu begrenzen.

4. System nach einem der vorhergehenden Ansprüche, **dadurch gekennzeichnet, dass** wenigstens eine der Einbaustellen dafür eingerichtet ist, eine Festplatte (40) aufzunehmen.

## Claims

1. Computer system comprising a computer system case equipped with a connector, at least one blade (10) of computer system components (40) which is designed to be inserted into said computer system case and connected to said connector of said case, and computer components (40) which are received in said blade, said blade comprising:
- a chassis (20) which is distinct from said case and which comprises a male connector (21) for electrically connecting said blade, said male connector being connected to the connector of said computer case;
- a computer component support (30) which is distinct from said chassis and distinct from said case and which has a plurality of open locations (31) suitable for receiving said computer components (40) by translational motion in a longitudinal direction of the location;
the component support (30) being mounted in such a way as to be movable along a slide link relative to the chassis (20) between a first position, in which the support is substantially inserted in the chassis, and a second position, in which the support is at least partially extracted from the chassis, so as to leave clearance in line with the set of locations (31) in the longitudinal direction of each of said locations in order to enable the insertion and the extraction of the computer components (40) by translational motion in said longitudinal direction of each of the locations;
said locations (31) having guide means (36) for guiding the computer components in translation, each of the locations (31) having at its bottom a connector (32) which is connected to the male connector (21) of the chassis, the connector (32) being suitable for electrically connecting the computer component when the latter is inserted in the location;
- a ribbon (35) of electrical wires connecting the connectors (32) of said locations (31) to an intermediate connector (34);
**characterized in that** said blade additionally comprises:
- a control device (22) which is mounted on the chassis and which carries both the intermediate connector (34) and the male connector (21), for connecting the computer components (40) to the chassis via the ribbon (35) and the intermediate connector (34) and for controlling said computer components (40);
- an electronic board (33) which carries the connectors (32) of said locations (31) and which is arranged at the bottom and on an inner face of the support, between the computer components (40) and said inner face;
and **in that** the slide link between the chassis and the support is formed by lower slides (37) and lateral slides (38) which are distinct from the lower slides, all of these being arranged between the chassis and the support, the lower slides having one rail (37A) which is fixed in relation to the chassis and another rail (37B) which is secured to the support and which bears the weight of the support in translation, and the lateral slides having one rail (38A) which is fixed in relation to the chassis and another rail (38B) which is secured to the support and which laterally guides the support in the chassis.

2. System according to claim 1, **characterized in that** all the longitudinal directions of the locations (31) are substantially parallel to one another, and the electronic board (33) is substantially perpendicular to all of said directions.

3. System according to the preceding claim, **characterized in that** means which form stops are provided on the lower and lateral slides (37, 38) so as to limit the travel of the support relative to the chassis when moving between said first and said second position.

4. System according to any one of the preceding claims, **characterized in that** at least one of the locations is suitable for receiving a hard disc (40).
